# EUROPEAN PATENT APPLICATION

(11) **EP 3 406 658 A1**
(43) Date of publication of application: **28.11.2018**
(21) Application number: 16886430.4
(22) Date of filing: 04.11.2016
(51) Int. Cl.: C08J 7/00, H05H 1/46, H05K 3/38

(54) **METHOD AND APPARATUS FOR SURFACE TREATING FLUORORESIN FILM**

(30) Priority: 18.01.2016 JP 2016007202
(71) Applicant: Sekisui Chemical Co., Ltd., Osaka-shi, Osaka 530-8565 (JP); Osaka University, Suita-shi, Osaka 565-0871 (JP)
(72) Inventor: NAKANO, Yoshinori, Kyoto-shi Kyoto 601-8105 (JP); UEHARA, Tsuyoshi, Kyoto-shi Kyoto 601-8105 (JP); YAMAMURA, Kazuya, Suita-shi Osaka 565-0871 (JP); OHKUBO, Yuji, Suita-shi Osaka 565-0871 (JP)
(74) Representative: Ter Meer Steinmeister & Partner
(86) International application number: PCT/JP2016/082749
(87) International publication number: WO 2017/126191

(57) **Abstract**

It is an objective of the present invention to improve coatability/printability and adhesiveness of a fluorine-based resin film to a sintered film of ink. A fluorine-based resin film 9 is passed through a treatment space 1a under near atmospheric pressure between electrodes 11, 21. A process gas composed of an inert gas is supplied to the treatment space 1a. Voltage is applied to between the electrodes to generate electric discharge in the treatment space 1a. A treatment surface 9a is heated to a temperature that is not higher than a continuous use temperature and not lower than a temperature lower than the continuous use temperature by 100 degrees C. A volume concentration of oxygen in the treatment space 1a is not higher than 1000 ppm.

## Description

### FIELD OF THE INVENTION

The present invention relates to an apparatus and a method for treating a surface of a fluorine-based resin film composed of a fluorine-based resin composition, and particularly relates to a surface treatment apparatus and method suitable for modifying a surface of a fluorine-based resin film to improve properties such as adhesiveness.

### BACKGROUND OF THE INVENTION

While a fluorine-based resin is superior in properties such as weather resistance and chemical resistance, the fluorine-base resin is not superior in adhesiveness to a thin film obtained by sintering ink such as silver ink or a metallic wiring pattern and in coatability/printablilty of a conductive pattern or the like.

Various kinds of methods for surface treatment are proposed to improve properties such as adhesiveness.

In Patent Document 1, a fluorine-based resin is treated with flame and treated with metallic sodium.

In Patent Document 2, a surface of a fluorine-based resin is etched with vacuum plasma under an atmosphere of mixture gas of H₂/N₂, for example, and the surface is further irradiated with excimer laser.

In Patent Document 3, a surface of a fluorine-based resin is sputter-etched, and subsequently treated with atmospheric-pressure plasma under an atmosphere containing unsaturated hydrocarbon such as acetylene.

### PRIOR ART DOCUMENTS

### PATENT DOCUMENTS

Patent Document 1: Japanese Examined Patent Application Publication No. S.63-10176
Patent Document 2: Japanese Unexamined Patent Application Publication No. H06-220228
Patent Document 3: Japanese Unexamined Patent Application Publication No. 2000-129015

### SUMMARY OF THE INVENTION

### PROBLEM TO BE SOLVED BY THE INVENTION

The flame treatment and the metallic sodium treatment disclosed in Patent Document 1 may pose major environmental problems. Moreover, a modified portion becomes less resistant to ultraviolet rays and heat.

The vacuum plasma etching and excimer laser treatment disclosed in Patent Document 2 requires major equipment that may result in high facility cost.

The sputter etching and the atmospheric-pressure plasma treatment by unsaturated hydrocarbon disclosed in Patent Document 3 are mainly for obtaining physical anchor effects, with little chemical modification effect on the surface of the fluorine-based resin film obtained. Moreover, the unsaturated hydrocarbon is easy to be powdered, which may decrease the productivity.

In view of the above, it is an objective of the present invention to modify a surface of a fluorine-based resin film composed of a fluorine-based resin composition to improve coatability/printability and adhesiveness to a thin film obtained by sintering ink, for example, or a metallic wiring pattern.

### MEANS FOR SOLVING THE PROBLEMS

To solve the problems mentioned above, the present invention provides a surface treatment apparatus for treating a treatment surface of a fluorine-based resin film composed of a fluorine-based resin composition, CHARACTERIZED IN THAT the apparatus includes: a pair of electrodes defining a treatment space under near atmospheric pressure therebetween, the pair of electrodes generating electric discharge in the treatment space by applying voltage; a carrying mechanism that carries the fluorine-based resin film through the treatment space; a process gas nozzle that supplies the treatment space with a process gas containing an inert gas; a heater that heats the treatment surface of the film under treatment; and a means for blocking oxygen inflow that blocks an inflow of oxygen into the treatment space to make an oxygen concentration of the treatment space lower than an oxygen concentration outside of the treatment space, wherein a temperature of the treatment surface is not higher than a continuous use temperature of the fluorine-based resin film and not lower than a temperature lower than the continuous use temperature by 100 degrees C, and a volume concentration of the oxygen in the treatment space is not higher than 1000 ppm.

The present invention provides a method for treating a treatment surface of a fluorine-based resin film composed of a fluorine-based resin composition, CHARACTERIZED IN THAT the method includes steps of: carrying the fluorine-based resin film through a treatment space formed between a pair of electrodes, the treatment space being under near atmospheric pressure; supplying the treatment space with a process gas containing an inert gas to bring the process gas into contact with the treatment surface in the treatment space; generating electric discharge in the treatment space by applying voltage to between the pair of electrodes; heating the treatment surface of the fluorine-based resin film; and blocking an inflow of oxygen into the treatment space to make an oxygen concentration of the treatment space lower than an oxygen concentration outside of the treatment space, wherein a temperature of the treatment surface is not higher than a continuous use temperature of the fluorine-based resin film and not lower than a temperature lower than the continuous use temperature by 100 degrees C, and a volume concentration of the oxygen in the treatment space is not higher than 1000 ppm.

In the plasma surface treatment according to the present invention, C-F bond of the fluorine-based resin composition of the fluorine-based resin film on the treatment surface side is cut off by plasma irradiation and C-C bond (cross-linked network), thereby cross-link, can be formed by heating. As a result of this surface modification, adhesiveness to a thin film obtained by sintering ink such as silver ink or a metallic wiring pattern can be improved and coatability/printablilty of a conductive pattern can be improved. Moreover, the improvement effect can be maintained for a long period of time.

By making the temperature during the treatment of the treatment surface not lower than the temperature lower than the continuous use temperature by 100 degrees C, preferably by 50 degrees C, failure to form C-C bond (cross-linked network) due to lack of heat can be prevented and formation of by-products on the treatment surface can be prevented, thereby, decrease of adhesiveness can be prevented.

By making the temperature during the treatment of the treatment surface not higher than the continuous use temperature, thermal damage to the fluorine-based resin film can be avoided.

The "continuous use temperature" used herein means an upper limit temperature under which strength of an object can be maintained at a value not less than 50 % of an initial value even if the object is left thereunder for a long period of time (40,000 hours).

By making the volume concentration of the oxygen in the treatment space not higher than 1000 ppm, preferably not higher than 100 ppm, blocking of the crosslinking of the fluorine-based resin composition can be prevented.

Preferably, the heater is disposed opposed to the treatment surface.

Thereby, the treatment surface side of the fluorine-based resin film can be surely heated to a predetermined temperature (not higher than the continuous use temperature and not lower than the temperature lower than the continuous use temperature by 100 degrees C, preferably by 50 degrees C). At the same time, a back side (opposite side to the treatment surface) of the fluorine-based resin film can be prevented from being heated at an excessively high temperature.

Preferably, the heater is disposed on an upstream side of the treatment space in a carrying direction of the carrying mechanism. Thereby, the fluorine-based resin film can be introduced to the treatment space for plasma treatment after being heated.

The fluorine-based resin film may be heated in the treatment space at the same time with plasma irradiation.

Preferably, the means for blocking oxygen inflow includes a gas curtain nozzle that forms a gas curtain of an inert gas in a side portion of the treatment space.

Preferably, a gas curtain of an inert gas is formed in a side portion of the treatment space.

Thereby, the oxygen inflow into the treatment space can be surely blocked, and the desired oxygen concentration (not higher than 1000 ppm, preferably not higher than 100 ppm) can be surely obtained.

Preferably, the gas curtain is formed in a side portion of the treatment space on the upstream side (entrance side) in the carrying direction of the fluorine-based resin film.

The inert gas component for the gas curtain may be of the same kind as or of a different kind from the inert gas component for the process gas.

The means for blocking oxygen inflow may include a shield wall disposed on the side portion of the treatment space.

The means for blocking oxygen inflow may include a process gas supplying unit and/or the carrying mechanism. The inflow of oxygen into the treatment space may be blocked by controlling a supply flow rate and/or a carrying speed of the process gas.

Preferably, the surface treatment of the present invention is performed under near atmospheric pressure. The "near atmospheric pressure" used herein means a pressure range of from 1.013 x 10⁴ to 50.663 x 10⁴ Pa. Considering the ease of pressure adjustment and simplification of device configuration, the pressure range is preferably from 1.333 x 10⁴ to 10.664 x 10⁴ Pa, and more preferably from 9.331 x 10⁴ to 10.397 x 10⁴ Pa.

The fluorine-based resin composing the fluorine-based resin composition may include polytetrafluoroethylene (PTFE), tetrafluoroethylene-perfluoroalkylvinylether copolymer (PFA), polyvinyl fluoride (PVF), tetrafluoroethylene-hexafluoropropylen copolymer (FEP), polychlorotrifluoroethylene (PCTFE), tetrafluoroethylene-ethylene copolymer (ETFE), chlorotrifluoroethylene-ethylene copolymer (ECTFE) and polyvinylidene fluoride (PVDF).

### ADVANTAGEOUS EFFECTS OF THE INVENTION

According to the present invention, the surface of the fluorine-based resin film can be modified, and the coatability/printability and the adhesiveness to a thin film obtained by sintering ink or a metallic wiring pattern or the like, for example, can be improved.

### BRIEF DESCRIPTION OF THE DRAWINGS

FIG. 1 is an explanatory side view of a surface treatment apparatus according to a first embodiment of the present invention, showing a schematic configuration of thereof.
FIG. 2 is an explanatory side view of a surface treatment apparatus according to a second embodiment of the present invention, showing a schematic configuration thereof.

### MODE FOR CARRYING OUT THE INVENTION

Embodiments of the present invention will be described hereinafter with reference to the drawings.

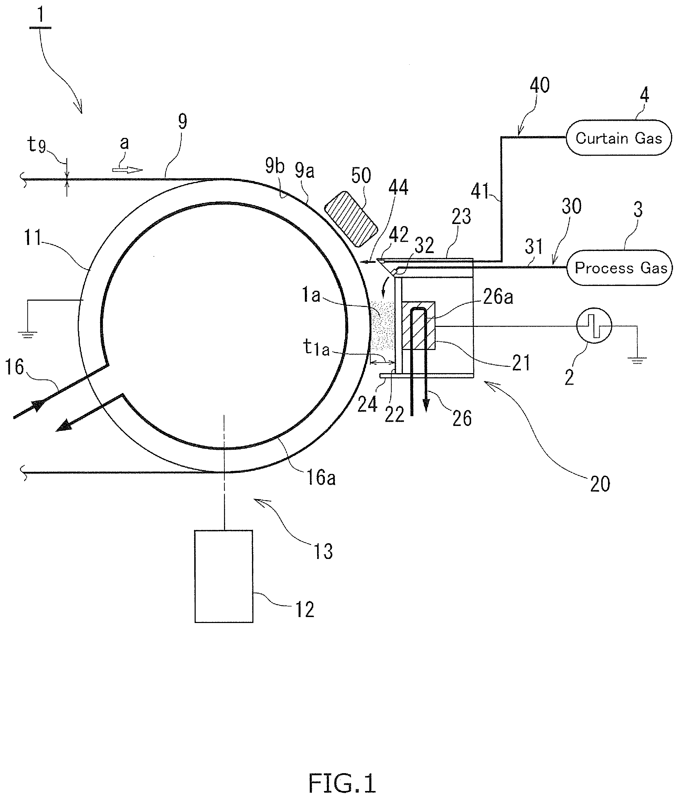

FIG. 1 shows a surface treatment apparatus 1 according to a first embodiment of the present invention. A target of the treatment is a fluorine-based resin film 9 composed of a fluorine-based resin composition. In this embodiment, the fluorine-based resin film 9 may be made of polytetrafluoroethylene (PTFE), for example. Continuous use temperature of the polytetrafluoroethylene (PTFE) is 260 degrees C.

A treatment surface 9a of the fluorine-based resin film 9 is modified with the surface treatment apparatus 1, and then, the modified surface 9a is coated with ink such as silver ink or coated with a circuit pattern of conductive paste with inkjet printing, for example. Coating method of the circuit pattern is not limited to the inkjet printing. The coating method may be selected from screen printing, gravure offset printing, flexo printing, or the like depending on a composition, viscosity or the like of the ink.

The surface treatment apparatus 1 includes a roll electrode 11, a plasma head 20 and a heater 50. The roll electrode 11 has a circular cylindrical configuration with an axis thereof extending orthogonal to the plane of FIG. 1. At least an outer peripheral portion of the roll electrode 11 is made of metal and an outer peripheral surface of the roll electrode 11 is coated with a solid dielectric layer (not shown). The metallic portion of the roll electrode 11 is electrically grounded, and thereby the roll electrode 11 serves as an earth electrode.

The fluorine-based resin film 9 passes around approximately halfway around an outer periphery of the roll electrode 11. The treatment surface 9a of the fluorine-based resin film 9 is oriented outward and a back side surface 9b is contacted with the roll electrode 11. A width direction of the fluorine-based resin film 9 is oriented to a direction orthogonal to the plane of FIG. 1 in parallel to the axis of the roll electrode 11. The direction orthogonal to the plane of FIG. 1 is referred to as "treatment width direction" hereinafter.

A rotary drive part 12 such as a motor is connected to the roll electrode 11. The roll electrode 11 is rotated by the rotary drive part 12 in a clock-wise direction of FIG. 1, for example. The fluorine-based resin film 9 is carried in a direction indicated by an arrow a of FIG. 1 accompanying the rotation of the roll electrode 11. The roll electrode 11 and the rotary drive part 12 constitute a carrying mechanism 13 for the fluorine-based resin film 9.

The roll electrode 11 is further provided with a temperature controller 16. The temperature controller 16 includes a temperature control medium passage 16a disposed inside the roll electrode 11. A temperature control medium is temperature-controlled (heated), and then passed through the temperature control medium passage 16a. Thereby, the temperature of the roll electrode 11 is controlled to be a set temperature. Heatable fluid such as water, oil and gas can be used as the temperature control medium. The set temperature of the roll electrode 11 is preferably not lower than 80 degrees C and not higher than a continuous use temperature of the fluorine-based resin film 9. In place of circulation of the temperature control medium, an electrothermal heater, an infrared heater or the like may be used as the temperature controller 16.

The plasma head 20 is disposed lateral (right side in FIG. 1) to a portion of the roll electrode 11 around which the film 9 passes. The plasma head 20 includes a flat-plate electrode 21 and a dielectric member 22. The flat-plate electrode 21 has a quadrangular cross-section and is composed of a metal plate extending in the treatment width direction orthogonal to the plane of FIG. 1. The flat-plate electrode 21 is connected to a high-frequency power source 2, thereby serving as a voltage applying electrode (hot electrode).

The roll electrode 21 and the flat-plate electrode 21 are opposed to each other in an opposing direction (left-right direction in FIG. 1) orthogonal to the treatment width direction, thereby constituting a pair of electrodes.

The dielectric member 22 is disposed on a surface of the plasma head 20, and thereby of the flat-plate electrode 21 opposed to the roll electrode 11. The dielectric member 22 is made of a ceramic (dielectric), for example.

A treatment space 1a is defined in a narrowest area between the dielectric member 22 and the roll electrode 11 and a periphery thereof. The treatment space 1a extends in the treatment width direction (direction orthogonal to the plane of FIG. 1). Opposite ends of the treatment space 1a in a longitudinal direction (vertical direction in FIG. 1) continue to an outside atmosphere. A pressure of the treatment space 1a is generally an atmospheric pressure. A thickness t₁ₐ (mm) of the narrowest area of the treatment space 1a in the opposing direction is preferably not greater than about 2.0 mm and greater than a thickness t₉ (mm) of the film 9 by not less than 0.1 mm (t₉ + 0.1 ≤ t₁ₐ ≤ 2). More preferably, t₁ₐ = 1 mm. If t₁ₐ < t₉ + 0.1, it is not easy to pass the fluorine-based resin film 9 having a maximum thickness (generally about 0.5 mm) through the treatment space 1a. If t₁ₐ > 2.0, electrical discharge may not be stable.

The thickness t₁ₐ of the treatment space 1a is exaggerated in the drawings.

Electrical field is applied to between the electrodes 21, 11 by electrical power supply from the high-frequency power source 2. Thereby, electrical discharge is generated in the treatment space 1a and the treatment space 1a becomes a discharge space.

The supplied power is determined according to a flow rate of a process gas and a carrying speed of the film. A range of an amount of power supply per unit area of a discharge surface (surface facing the treatment space 1a) of the flat-plate electrode 21 is preferably 0.5 to 100 W/cm² • sec and more preferably 5 to 50 W/cm² • sec. If the amount of power supply is less than the range, a surface treatment effect may be insufficient because of shortage of power supply. If the amount of power supply is greater than the range, the fluorine-based resin film 9 may be damaged by electrical field or by heat.

A portion of the fluorine-based resin film 9 passing around the roll electrode 11 is positioned in the treatment space 1a. By rotation of the roll electrode 11 in a clockwise direction, the fluorine-based resin film 9 is carried downward in the treatment space 1a.

The flat-plate electrode 21 is provided with a temperature controller 26. The temperature controller 26 includes a temperature control medium passage 26a disposed inside the flat-plate electrode 21. The temperature control medium is temperature-controlled (heated), and then passed through the temperature control medium passage 26a. Thereby, the temperature of the flat-plate electrode 21 is controlled to be a set temperature. Heatable fluid such as water, oil and gas can be used as the temperature control medium. The set temperature of the flat-plate electrode 21 is preferably not lower than 80 degrees C and not higher than the continuous use temperature of the fluorine-based resin film 9. In place of circulation of the temperature control medium, an electrothermal heater, an infrared heater or the like may be used as the temperature controller 26.

A nozzle unit 23 is disposed in a side portion of the plasma head 20 on an upstream side in a film carrying direction (entrance side of the treatment space 1a, above in FIG. 1). The nozzle unit 23 extends in the treatment width direction orthogonal to the plane of FIG. 1 through a length generally the same as a length of the plasma head 20.

The nozzle unit 23 is provided with a process gas nozzle 32 and a curtain gas nozzle 42. The process gas nozzle 32 is obliquely open toward the treatment space 1a. A process gas passage 31 extends from a process gas source 3 through the nozzle unit 23 and is connected to the process gas nozzle 32. The process gas nozzle 32 disperses the process gas from the gas passage 31 in the treatment width direction orthogonal to the plane of FIG. 1 and homogeneously blows out the process gas toward the treatment space 1a. The process gas is a discharge generating gas for generating stable plasma discharge. An inert gas is used as the process gas. The inert gas may be noble gas such as argon (Ar) and helium (He). Nitrogen (N₂) can also be used as the inert gas..

The process gas source 3, the process gas passage 31 and the process gas nozzle 32 constitute a process gas supplying unit 30.

The curtain gas nozzle 42 is disposed in the nozzle unit 23 on the upstream side (above in FIG. 1) with respect to the process gas nozzle 32 in the film carrying direction. The curtain gas nozzle 42 is open toward the roll electrode 11, and therefore toward the treatment surface 9a of the fluorine-based resin film 9. A curtain gas passage 41 extends from a curtain gas source 4 through the nozzle unit 23 and is connected to the curtain gas nozzle 42. The curtain gas nozzle 42 disperses the curtain gas from the gas passage 41 in the treatment width direction orthogonal to the plane of FIG. 1 and homogeneously blows out the curtain gas. Thereby, a gas curtain 44 is formed between the curtain gas nozzle 42 and the roll electrode 11. An inert gas such as argon (Ar), helium (He) and nitrogen (N₂) is used as the curtain gas.

The curtain gas source 4, the curtain gas passage 41 and the curtain gas nozzle 42 constitute a gas curtain forming means 40.

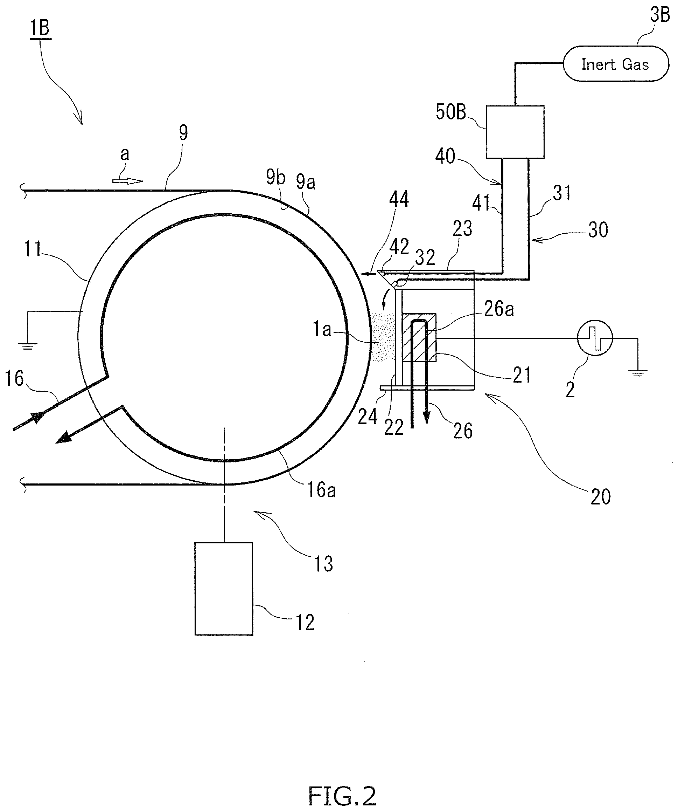

The process gas and the curtain gas may be made of the same kind of inert gas. In this case, the process gas source 3 and the curtain gas source 4 may be composed of a common inert gas source. The gas passages 31, 41 may be branched from the common inert gas source and respectively connected to the nozzles 32, 42 (refer to FIG. 2).

Alternatively, the process gas and the curtain gas may be made of different kinds of inert gas. The process gas may be Ar or He and the curtain gas may be N₂, for example.

A shield wall 24 is disposed in a downstream side portion of the plasma head 20 in the film carrying direction (exit side of the treatment space 1a, below in FIG. 1). The shield wall 24 is protruded toward the roll electrode 11 with respect to the dielectric member 22. A gap greater than a thickness of the fluorine-based resin film 9 is formed between a distal end of the shield wall 24 and the roll electrode 11.

The shield wall 24 and the gas curtain forming means 40 constitute a "means for blocking oxygen inflow."

The heater 50 is disposed on the upstream side (above in FIG. 1) with respect to the plasma head 20, therefore with respect to the treatment space 1a, in the film carrying direction. The heater 50 is disposed opposed to the roll electrode 11, and therefore opposed to the treatment surface 9a of the fluorine-based resin film 9. The fluorine-based resin film 9, particularly the treatment surface 9a thereof is heated by the heater 50.

The heater 50 may be a thermal transfer roll, an infrared heater, a gas heating device or the like. There is no limitation to the heater 50 as long as the heater 50 can heat the treatment surface 9a to a set temperature.

The set temperature for heating the treatment surface 9a by the heater 50 is not higher than the continuous use temperature of the fluorine-based resin film 9 and not lower than a temperature lower than the continuous use temperature by 100 degrees C, preferably not higher than the continuous use temperature and not lower than a temperature lower than the continuous use temperature by 50 degrees C. In a case of the fluorine-based resin film 9 made of polytetrafluoroethylene (continuous use temperature: 260 degrees C), the set temperature is 160 to 260 degrees C, preferably 210 to 260 degrees C.

A method for treating the surface of the fluorine-based resin film 9 using the surface treatment apparatus 1 will be described hereinafter.

### <Carrying Step>

The fluorine-based resin film 9 to be treated passes around the roll electrode 11. Then, the roll electrode 11 is turned in a clockwise direction in FIG. 1, and the fluorine-based resin film 9 is carried in a direction of arrow a at a predetermined speed.

### <Heating Step>

The fluorine-based resin film 9 is heated by the heater 50 to the set temperature (160 to 260 degrees C, preferably 210 to 260 degrees C) on the upstream side of the plasma head 20, therefore on the upstream side of the treatment space 1a, along the carrying direction. Since the heater 50 is opposed to the treatment surface 9a of the fluorine-based resin film 9, the fluorine-based resin film 9, particularly a surface portion thereof including the treatment surface 9a can be surely heated to the set temperature.

### <Temperature Controlling Step>

And the roll electrode 11 is heated to not lower than 80 degrees C and not higher than 260 degrees C (continuous use temperature) by the temperature controller 16.

And the flat-plate electrode 21 is heated to not lower than 80 degrees C and not higher than 260 degrees C (continuous use temperature) by the temperature controller 26.

Thereby, the fluorine-based resin film 9 can be prevented from being cooled after being heated by the heater 50, thereby a temperature of the fluorine-based resin film 9 can be maintained at the set temperature.

By the rotation of the roll electrode 11, a portion of the fluorine-based resin film 9 heated to the set temperature is introduced to between the plasma head 20 and the roll electrode 11 and into the treatment space 1a.

### <Process Gas Supplying Step>

At the same time, the process gas is blown out from the nozzle 32 to be supplied to the treatment space 1a.

### <Gas Curtain Forming Step (Oxygen Inflow Blocking Step)>

The gas curtain 44 is formed at an entrance portion of the treatment space 1a by blowing out the curtain gas from the nozzle 42. An outside atmosphere gas (air) can be blocked from entering into the treatment space 1a by the gas curtain 44. Thereby, oxygen in the atmosphere can be blocked from entering into the treatment space 1a. Moreover, oxygen can be blocked from entering into the treatment space 1a from the exit side by the shield wall 24. Thereby, an oxygen concentration of the treatment space 1a can be made lower than an oxygen concentration outside of the treatment space 1a. Preferably, the oxygen concentration (volume concentration) of the treatment space 1a can be made not higher than 1000 ppm, more preferably not higher than 100 ppm.

### <Discharge Generating Step>

At the same time, a high-frequency voltage is applied to between the electrodes 21, 11 from the high-frequency power source 2. Thereby, the discharge is generated in the treatment space 1a and the process gas becomes plasma. The plasma is irradiated onto the treatment surface 9a of the fluorine-based resin film 9 in the treatment space 1a.

By the plasma irradiation, a C-F bond of a surface layer of the fluorine-based resin film 9 including the treatment surface 9a can be cut off. Moreover, it can be understood that by setting a treatment temperature to near the continuous use temperature (160 to 260 degrees C, preferably 210 to 260 degrees C) of the fluorine-based resin film 9, a new C-C bond can be formed near the surface layer of the fluorine-based resin film 9 and a cross-linked network can be formed. Thereby, the surface layer of the fluorine-based resin film 9 can be made a cross-linked fluorine-based resin. By making the oxygen concentration of the treatment space 1a not higher than 1000 ppm, preferably not higher than 100 ppm, formation of a new C-C bond can be blocked and the fluorine-based resin can be surely cross-linked.

It can be understood that as a result of cutting off the C-F bond and newly forming the C-C bond, F atoms may be blown away and a density of the F atoms in the treatment surface 9a may be made smaller than before the treatment.

The treatment surface 9a can be surface modified to have a greater surface free energy in this manner.

An ink such as silver ink (Ag), for example, is applied to the surface-modified treatment surface 9a. A sintered film such as a thin film or a wiring pattern is obtained by sintering the silver ink. Alternatively, a conductive pattern is coated/printed on the treatment surface 9a with ink-jet printing or screen printing or the like.

Since the surface free energy of the treatment surface 9a is increased, adhesiveness to the sintered film of the silver ink and coatability/printability of the treatment surface 9a can be improved. Moreover, the effect of the treatment can be maintained for a long period of time. Specifically, good adhesiveness and good coatability/printability can be secured even after one to a few months after the surface treatment.

As well as the adhesiveness to the sintered film of the silver ink, adhesiveness to a sintered film such as a thin film or a wiring pattern obtained by sintering a copper ink or a copper paste or the like can also be improved. As well as adhesiveness to inorganic conductive materials such as silver and copper, adhesiveness to organic conductive materials can also be improved. Moreover, via a general-use adhesive such as epoxy adhesive, adhesiveness to a general-purpose resin composition (polypropylene (PP), polyethylene (PE), polyethylene terephthalate (PET), polyimide (PI) and nylon, for example) can also be improved. That is, adhesiveness to conductive materials (regardless of inorganic or organic) and coatability/printability of the film 9 composed of inadhesive fluorine-based resin composition can be improved.

Moreover, via a general-use adhesive such as epoxy adhesive, adhesiveness to synthetic rubber (isoprene rubber, butadiene rubber, styren-butadiene rubber, nitrile rubber, ethylene-propylene rubber and acrylic rubber, for example) can also be improved.

By making a heating temperature of the fluorine-based resin film 9 not higher than a continuous use temperature, a thermal damage to the fluorine-based resin film 9 can be avoided.

Since the surface treatment apparatus 1 conducts treatment under the atmospheric pressure, it does not require a large-scale vacuum facilities or the like. Moreover, the device configuration can be open. For example, it is not required to replace an entirety of inside a chamber enclosing the entirety of the apparatus with inert gas. Therefore, facility cost can be constrained. Moreover, continuous stable productivity is high and a quality of the fluorine-based resin film 9 can be stabilized.

Other embodiments of the present invention will be described hereinafter. Same reference numerals are used in the drawings to designate same parts as those in the foregoing embodiment and description thereof will be omitted.

FIG. 2 shows a surface treatment apparatus 1B according to a second embodiment of the present invention. In the surface treatment apparatus 1B, a process gas supplier 30 and a gas curtain forming means 40 are provided as parts of a heater. Specifically, the surface treatment apparatus 1B is provided with an inert gas source 3B that is common to a process gas and a curtain gas and a gas heating device 50B that is a main part of the heater. The gas heating device 50B is connected to the inert gas source 3B. The gas heating device 50B is bifurcated into a process gas passage 31 and a curtain gas passage 41 respectively connected to a process gas nozzle 32 and a curtain gas nozzle 42 of a nozzle unit 23.

An inert gas from the gas source 3B is heated by the gas heating device 50B to a temperature that is not higher than a continuous use temperature of a fluorine-based resin film 9 and not lower than a temperature lower than the continuous use temperature by 100 degrees C, preferably by 50 degrees C. A portion of the inert gas after heating is blown out as a process gas from the process gas nozzle 32 via the process gas passage 31 and brought into contact with a treatment surface 9a of the fluorine-based resin film 9. The process gas is introduced into a treatment space 1a and becomes plasma. Another portion of the inert gas after heating is blown out as a curtain gas from the curtain gas nozzle 42 via the curtain gas passage 41 to form a gas curtain 44 and brought into contact with the treatment surface 9a of the fluorine-based resin film 9.

The treatment surface 9a of the fluorine-based resin film 9 is heated to a temperature that is not higher than the continuous use temperature and not lower than a temperature lower than the continuous use temperature by 100 degrees C, preferably by 50 degrees C. Subsequently, the fluorine-based resin film 9 is introduced into the treatment space 1a to be subjected to a plasma surface treatment.

The present invention is not limited to the embodiments described above. Various modifications can be made without departing from the scope and spirit of the invention.

For example, the composition of the fluorine-based resin film 9 is not limited to polytetrafluoroethylene (PTFE), but may be tetrafluoroethulene-perfluoroalkylvinylether copolymer (PFA), polyvinyl fluoride (PVF), etrafluoroethylene-hexafluoropropylen copolymer (FEP), polychlorotrifluoroethylene (PCTFE), tetrafluoroethylene-ethylene copolymer (ETFE), chlorotrifluoroethylene-ethylene copolymer (ECTFE), polyvinylidene fluoride (PVDF) or the like. It is not required that the fluorine-based resin film 9 should have a single composition but may be composed of plural kinds of fluoride-based resin.

It is not required that the pair of electrodes should be composed of a roll electrode 11 and a flat-plate electrode 21. The pair of electrodes may be composed of a pair of roll electrodes or a pair of flat-plate electrodes.

A gas curtain may be formed in the exit side (below in FIGS. 1 and 2) of the treatment space 1a or in the opposite end portions thereof in the treatment width direction (direction orthogonal to the plane of FIGS. 1 and 2).

A shield wall 24 may be disposed in the entrance side (above in FIGS. 1 and 2) of the treatment space 1a or in the opposite end portions thereof in the treatment width direction (direction orthogonal to the plane of FIGS. 1 and 2).

In the second embodiment (FIG.2), the gas heating device 50B may heat only the process gas or only the curtain gas instead of both the process gas and the curtain gas.

### Example 1

Examples are described hereinafter. It is to be understood that the present invention is not limited to these examples.

In Example 1, surface treatment of a fluorine-based resin film 9 was performed using an apparatus substantially the same as the surface treatment apparatus 1B shown in FIG. 2. Specifically, while the fluorine-based resin film 9 was being carried passing around a roll electrode 11 (Carrying Step), a heated process gas was supplied to a treatment space 1a (Process Gas Supplying Step, Heating Step) and an electric field was applied to between electrodes 21, 11 to generate atmospheric pressure plasma discharge (Discharge Generating Step) and a gas curtain 44 was formed by a heated curtain gas (Oxygen Inflow Blocking Step, Heating Step).

### <Fluorine-Based Resin Film 9>

A material of the fluorine-based resin film 9, the substance to be treated was polytetrafluoroethylene (PTFE). Accordingly, the continuous use temperature was 260 degrees C.

A thickness of the fluorine-based resin film 9 was 0.2 mm.

### <Device Configuration>

A length of the electrodes 21, 11, therefore a length of the treatment space 1a, in a treatment width direction (direction orthogonal to the plane of FIG. 2) was 640 mm.

A width of the flat-plate electrode 21 (dimension in a vertical direction of FIG. 2) was 30 mm.

A thickness of a narrowest area of the treatment space 1a was 1mm.

### <Applied Voltage>

The commercial alternating current power was converted into direct current power at a high-frequency power source 2. The direct current power was transformed into high-frequency power and supplied to the flat-plate electrode 21.

A supply direct current voltage was 150 V, a supply direct current electricity was 0.6 A and a supply power was 90 W.

An applied voltage (peak-to-peak voltage Vpp) between the electrodes 21, 11 was Vpp = 4.2 kV.

### <Treatment Speed>

A treatment speed (carrying speed of the fluorine-based resin film 9) was 0.3 m/min.

### <Process Gas>

Ar was used as the process gas.

A flow rate of the process gas was 50L/min.

### <Curtain Gas>

Ar was used as the curtain gas.

A flow rate of the curtain gas was 25L/min.

As a result, an oxygen concentration (voltage concentration) of the treatment space 1a was 950 ppm.

A suction type oxygen concentration meter "Oxygen Analyzer LC-850KS" made by Toray Engineering Co., Ltd. was used for measurement of the oxygen concentration. A narrow suction tube of the oxygen concentration meter was brought into the treatment space 1a. A portion of the gas in the treatment space 1a was sucked and measured. A suction amount was 100 mL/min.

### <Setting Temperature>

The process gas and the curtain gas were heated by a gas heating device 50B. The fluorine-based resin film 9 was heated by blowing these gases against the fluorine-based resin film 9. A gas heating temperature, therefore a treatment temperature of a treatment surface 9a was 250 degrees C.

A temperature of the roll electrode 11 and a temperature of the flat-plate electrode 21 were both 80 degrees C. Water was heated by a chiller into boiling water and flown through respective temperature control passages 16a, 26a of the electrodes 11, 21.

The treatment surface 9a of the fluorine-based resin film 9 after the surface treatment was harder than the one before the treatment and also harder than a back side surface 9b after the surface treatment. From this, it is assumed that molecules of the fluorine-based resin on a surface layer including the treatment surface 9a were cross-linked.

### <Evaluation>

### (1) Adhesiveness to a sintered film of Ag ink

Adhesiveness of the fluorine-based resin film 9 surface-treated in the foregoing manner to a sintered film of Ag ink was measured in the following manner:
A sample was cut out from the fluorine-based resin film 9 after the surface-treatment. A dimension of the sample was 30 mm (length) x 10 mm (width).

A treatment surface 9a of the sample was coated with Ag ink.

As the Ag ink, Model Number AG-SI-112 made by NOF Corporation was used.

A spin-coater was used as a means for coating. A rotation speed of the spin-coater was 2000 rpm. A coating time was 10 seconds. An Ag ink sintered film was obtained by sintering the Ag ink by heating the Ag ink at 120 degrees C for 20 minutes after the coating. After that, the sintered film was cooled by ambient air.

In a separate step, two elongated stainless plates having a width (5mm) of half a width of the sample were prepared. The two elongated stainless plates were placed side by side in a width direction and an adhesive was applied thereto. The Ag ink sintered film side of the sample was contacted with the adhesive on the stainless plates and the sample was adhered to the stainless plates.

Two-component curing epoxy adhesive was used as the adhesive. Specifically, a mixture of two-component epoxy adhesive AV138 and HV998 (both by Nagase ChemteX Corporation) mixed at a mas ratio of 5 to 2 was used.

Subsequently, the Ag ink sintered film of the sample and the two elongated stainless plates were adhered by hardening the epoxy adhesive by heating with a heater. A heating temperature was 80 degrees C and a heating time was 30 minutes.

Subsequently, 90 degree peel test was conducted based on JIS K6584-1. A digital force gauge ZP-200 (by Imada Co., Ltd.) and an electric stand MX-500N (by Imada Co., Ltd.) were used for the test. The sample and the elongated stainless plates were horizontally placed on a stage of the electric stand with the sample oriented upward and the stainless plates oriented downward. At the same time, one end portion of the sample was bent 90 degrees upward and fixed to the digital force gauge, and the stage was scanned. A scanning speed was 30 mm/min. Adhesion strength of the sample to the sintered film of Ag ink per 1 mm width of the sample was calculated from a reading of the digital force gauge when the sample is peeled apart from the sintered film of Ag ink.

The result was 1.0 N/mm, showing that a sufficient adhesion strength was obtained.

### (2) Coatability/Printability

The surface-treated fluorine-based resin film 9 was pattern coated by inkjet printing.

Line/Space = 50/50 µm was drawn as a pattern to be coated.

Model Number AG-SI-112 made by NOF Corporation was used as the inkjet ink.

The result of printing was good by visual observation with no bleeding of ink observed (indicated by "O", in FIG. 1).

### Example 2

In Example 2, He was used as a process gas and a curtain gas. Other conditions and procedures of treatment were the same as those of Example 1. Evaluation method after the treatment was also the same as that of Example 1.

As a result, adhesion strength to a sintered film of ink was 1.1 N/mm.

As to the coatability/printability, printed condition was good with no bleeding of ink.

### [Comparison Example 1]

In a Comparison Example 1, a temperature of the fluorine-based resin film 9 for the surface-treatment was set at 80 degrees C. Other conditions and procedures of treatment were the same as those of Example 1. Evaluation method after the treatment was also the same as that of Example 1.

As a result, adhesion strength to a sintered film of ink was 0.2 N/mm, showing a bad adhesiveness.

By inkjet printing, the ink was rejected and failed to print, showing a bad coatability/printability (indicated by "x", in FIG. 1).

### [Comparison Example 2]

In a Comparison Example 2, a temperature of the fluorine-based resin film 9 for the surface-treatment was set at 150 degrees C. Other conditions and procedures of treatment were the same as those of Example 1. Evaluation method after the treatment was also the same as that of Example 1.

As a result, adhesion strength to a sintered film of ink was 0.3 N/mm, showing a bad adhesiveness.

By inkjet printing, the ink was rejected and failed to print, showing a bad coatability/printability.

### [Comparison Example 3]

In a Comparison Example 3, an oxygen concentration (volume concentration) of the treatment space 1a was made to be 3000 ppm by intentionally introducing the oxygen into the treatment space 1a. Other conditions and procedures of treatment were the same as those of Example 1. Evaluation method after the treatment was also the same as that of Example 1.

As a result, adhesion strength to a sintered film of ink was 0.2 N/mm, showing a bad adhesiveness.

By inkjet printing, the ink was rejected and failed to print, showing a bad coatability/printability.

Table 1 shows treatment conditions and evaluation results of the Examples 1 and 2 and the Comparison Examples 1 to 3.

**[Table 1]**

| | Example 1 | Example 2 | Comparison Example 1 | Comparison Example 2 | Comparison Example 3 |
|---|---|---|---|---|---|
| Apparatus Used | FIG. 2 | FIG. 2 | FIG. 2 | FIG. 2 | FIG. 2 |
| Film Material | PTFE | PTFE | PTFE | PTFE | PTFE |
| Process Gas | Ar | He | Ar | Ar | Ar |
| Flow Rate | 50 L/min | 50 L/min | 50 L/min | 50 L/min | 50 L/min |
| Curtain Gas | Ar | He | Ar | Ar | Ar |
| Flow Rate | 25 L/min | 25 L/min | 25 L/min | 25 L/min | 25 L/min |
| Film Temperature | 250 degrees C | 250 degrees C | 80 degrees C | 150 degrees C | 250 degrees C |
| Roll Electrode Temperature | 80 degrees C | 80 degrees C | 80 degrees C | 80 degrees C | 80 degrees C |
| Flat-Plate Electrode Temperature | 80 degrees C | 80 degrees C | 80 degrees C | 80 degrees C | 80 degrees C |
| Discharge Space Oxygen Concentration | 950 ppm | 950 ppm | 950 ppm | 950 ppm | 3000 ppm |
| Sintered Film Adhesion Strength | 1.0 N/mm | 1.1 N/mm | 0.2 N/mm | 0.3 N/mm | 0.2 N/mm |
| Coatability/ Printability | ○ | ○ | x | x | x |

From the results of the examples and the comparison examples, it was confirmed that the coatability/printability and the adhesiveness of the fluorine-based resin film 9 to the sintered film of ink can be improved by bringing the temperature of the treatment surface 9a of the fluorine-based resin film 9 to near the continuous use temperature and making the oxygen concentration of the treatment space 1a sufficiently small.

### INDUSTRIAL APPLICABILITY

The present invention may be applied to improve coatability/printability and adhesiveness of a film composed of a fluorine-based resin composition such as polytetrafluoroethylene (PTFE) to a sintered film of ink, for example.

### EXPLANATION OF REFERENCE NUMERALS

- 1: surface treatment apparatus
- 1a: treatment space
- 2: power source
- 9: fluorine-based resin film
- 9a: treatment surface
- 11: roll electrode (earth electrode)
- 13: carrying mechanism
- 16: temperature controller
- 21: flat-plate electrode (voltage applying electrode)
- 24: shield wall (means for blocking oxygen inflow)
- 26: temperature controller
- 30: process gas supplying unit
- 32: process gas nozzle
- 40: gas curtain forming means (means for blocking oxygen inflow)
- 42: curtain gas nozzle
- 44: gas curtain
- 50: heater

## Claims

1. A surface treatment apparatus for treating a treatment surface of a fluorine-based resin film composed of a fluorine-based resin composition, **CHARACTERIZED IN THAT** the apparatus comprises:
a pair of electrodes defining a treatment space under near atmospheric pressure therebetween, the pair of electrodes generating electric discharge in the treatment space by applying voltage;
a carrying mechanism that carries the fluorine-based resin film through the treatment space;
a process gas nozzle that supplies the treatment space with a process gas containing an inert gas;
a heater that heats the treatment surface of the film under treatment; and
a means for blocking oxygen inflow that blocks an inflow of oxygen into the treatment space to make an oxygen concentration of the treatment space lower than an oxygen concentration outside of the treatment space, wherein
a temperature of the treatment surface is not higher than a continuous use temperature of the fluorine-based resin film and not lower than a temperature lower than the continuous use temperature by 100 degrees C, and
a volume concentration of the oxygen in the treatment space is not higher than 1000 ppm.

2. The surface treatment apparatus according to claim 1, wherein the heater is disposed opposed to the treatment surface.

3. The surface treatment apparatus according to claim 1 or 2, wherein the heater is disposed on an upstream side of the treatment space in a carrying direction of the carrying mechanism.

4. The surface treatment apparatus according to any one of claims 1 to 3, wherein the means for blocking oxygen inflow includes a gas curtain nozzle that forms a gas curtain of an inert gas in a side portion of the treatment space.

5. A method for treating a treatment surface of a fluorine-based resin film composed of a fluorine-based resin composition, **CHARACTERIZED IN THAT** the method comprises steps of:
carrying the fluorine-based resin film through a treatment space formed between a pair of electrodes, the treatment space being under near atmospheric pressure;
supplying the treatment space with a process gas containing an inert gas to bring the process gas into contact with the treatment surface in the treatment space;
generating electric discharge in the treatment space by applying voltage to between the pair of electrodes;
heating the treatment surface of the fluorine-based resin film; and
blocking an inflow of oxygen into the treatment space to make an oxygen concentration of the treatment space lower than an oxygen concentration outside of the treatment space, wherein
a temperature of the treatment surface is not higher than a continuous use temperature of the fluorine-based resin film and not lower than a temperature lower than the continuous use temperature by 100 degrees C, and
a volume concentration of the oxygen in the treatment space is not higher than 1000 ppm.

6. The method for treating a surface according to claim 5, wherein a gas curtain of an inert gas is formed in a side portion of the treatment space.
